# EUROPEAN PATENT APPLICATION

(11) **EP 0 928 070 A2**
(43) Date of publication of application: **07.07.1999**
(21) Application number: 98310574.3
(22) Date of filing: 22.12.1998
(51) Int. Cl.: H03M 7/30, G06F 17/21, G06F 17/30

(54) **Compression of documents with markup language that preserves syntactical structure**

(30) Priority: 29.12.1997 US 999518
(71) Applicant: Unwired Planet, Inc., Redwood City, California 94063 (US)
(72) Inventor: The designation of the inventor has not yet been filed
(74) Representative: Suèr, Steven Johannes

(57) **Abstract**

Communication channels between mobile telephones and networks like the Internet have very limited bandwidths. The transmission of documents expressed in various forms like markup languages is made more efficient by compressing document elements into codes such that syntactical characteristics of the elements can be determined readily from the encoded representations. An indication of the presence of syntax information like markup language tag attributes and content is conveyed in a position relative to the code beginning that is predefined. Preferably, the position is independent of the type of element that is represented. In this manner, compressed or encoded representations of document elements can be processed efficiently without need for expansion or decoding. In addition, future extensions to the markup language can be processed efficiently by existing encoders and decoders that are not cognizant of the new extensions.

## Description

The present invention pertains generally to the compression of information for transmission to devices over very low bandwidth communication channels. More particularly, the present invention pertains to the compression of information having a syntactical structure, such as a document description that conforms to a generalized markup language, for transmission to a wireless device such as a handheld mobile telephone.

Networks like the Internet have been in existence for years; however, they have not been a popular medium of information exchange until very recently. The recent explosive growth in usage of the Internet, for example, is due in large part to the development of devices and methods that simplify the actions a user must take to access and peruse multimedia information stored across a network of servers. References to resources, known as hyperlinks, allow disparate pieces of information to be organized in nonsequential ways and allow a user to easily navigate among the linked information. By assigning a unique identifier, known as a Uniform Resource Locator (URL), to each distinct piece of multimedia information available throughout a network, information can be readily accessed without regard to where it is stored. Network clients and servers participating in such a "hypermedia" network are referred to herein as hypermedia clients and hypermedia servers, respectively.

One significant development that has contributed to this growth is the use of facilities such as "markup languages" and associated processes to define and implement a broad variety of elements specifying various syntactical characteristics of documents. Many markup languages in use today conform to international standard ISO 8879:1986, which defines a set of basic rules for a tag-based language referred to herein as the Standard Generalized Markup Language (SGML). Perhaps the most widely used markup language on the Internet that conforms to SGML is the Hypertext Markup Language (HTML).

Documents that are represented by a tag-based markup language are typically displayed and manipulated by software applications called browsers or readers. These software applications implement processes conforming to the appropriate markup language rules to parse and interpret information representing documents so that the documents can be displayed properly.

Information representing a document according to a SGML-like markup language generally comprises several elements that have tags and possibly associated tag attributes and tag content. These elements convey syntactical characteristics of the information conveyed in the document.

A tag identifies the element type. In HTML, for example, the element that represents the entire document is identified by tags marking the start and end of the document, elements representing a paragraph of text are identified by a tag that marks the start of the paragraph, and text that is to be displayed with an underline is identified by tags that mark the start and end of the underlining.

Tag attributes provide information that specifies one or more characteristics of the element. A tag that represents an image file to be embedded into a document, for example, includes an attribute that specifies the name of the image file to be embedded. According to the specification of a markup language, a tag attribute may be optional or required according to the associated tag type.

Tag content represents information that is generally intended to be displayed or otherwise available for manipulation by a user. Tag content may be optional or required according to the type of tag, and it may contain other "nested" elements which in turn have tags, attributes and content.

Markup languages such as those that conform to SGML can provide very flexible and powerful facilities for implementing document elements because SGML itself is very flexible. This flexibility is not without cost. Additional bandwidth is required to convey the tags and tag attributes and additional resources are required to parse and interpret the tags and tag attributes. In HTML, tags and attributes are expressed by character strings in a form similar to <***tagid name=value***> where *tagid* is the tag identifier, *name* is the name of an attribute and *value* is the value assigned to that attribute. A tag may have more than one attribute.

The additional bandwidth and resources required to convey and process the tags and tag attributes is not a significant disadvantage in many situations because personal computers and other workstations with sufficient computing power and communication channels with sufficient bandwidth are readily available.

There is, however, a growing interest to provide access to hypermedia servers connected to networks such as the Internet through mobile devices, particularly handheld devices like wireless telephones. These devices are characterized by severe limitations in processing power and memory space. Furthermore, the bandwidth of the communication channels connecting the mobile devices to the rest of the network is also severely limited.

A wireless telephone has only a small fraction of the resources provided by a typical desktop or portable computer. Typically, the processing power is less than one percent of the processing power in many computers and the memory space is generally much less than 150 kilobytes (kB). The communication path is often in the range of 400 to 19,200 bits per sec. and the cost using that communication path is measured in terms of United States dollars per 100 kB or more.

The limited bandwidth of these communication channels can be used more effectively by reducing the capacity requirements of the information conveyed along these channels. Information capacity requirements can be reduced by employing some form of data or information compression.

General purpose compression schemes such as Huffman encoding have been considered but, unfortunately, general purpose schemes are not attractive because the resulting compressed information obscures the syntactical characteristics of the underlying information. In other words, the identify of tags and the presence or absence of tag attributes and tag content cannot be easily determined from the compressed representation. Furthermore, general purpose compression schemes usually cannot reduce information capacity requirements as much as compression schemes that are based on a specific markup language.

Various compression schemes based on specific markup languages such as HTML have been considered. This type of compression scheme is able to achieve higher levels of compression by exploiting known characteristics of the specific markup language For example, a markup-language specific compression scheme need not allow for the possibility of conveying tag content for those tags which cannot have content. Unfortunately, these schemes require that the browser or expansion process be able to process or expand all compressed elements. Extensions or changes to a markup language cannot be recovered from a compressed representation unless browsers are modified to process the new language features; otherwise, compression of the new feature obscures syntactical characteristics of those elements incorporating the new feature as well as any nested elements. Significantly, a browser must be modified even if it is incorporated into an application or device that cannot use or does not need to use the new feature.

For example, if a markup language-based compression scheme is extended to compress a new display format, a browser cannot recover that display format information from the compressed representation unless the browser is modified to include the processing required to expand the new feature. Furthermore, without such modification, the browser may not be able to ignore or skip the new feature and expand the remaining information because its processing capabilities are unable to determine the extents of the new compressed feature.

It is an object of the present invention to reduce the bandwidth and resources required to convey and process information representing documents in a way that does not obscure syntactical characteristics of the underlying document elements.

According to one aspect of the present invention, a method for reducing capacity requirements of input information representing a document comprises receiving the input information and identifying a plurality of elements therein, each element having a respective type and at least some of the elements having syntax information representing one or more respective syntactical characteristics, generating a plurality of codes, a respective code having a beginning and representing at least a portion of a respective element in a form having an information capacity requirement that is lower than the information capacity requirement of the represented portion, the respective code conveying the respective element type and a syntax indication indicating presence or absence of syntax information for the respective element, and the respective code conveying the syntax indication in a predefined position relative to the beginning of the respective code, and generating encoded information representing the document by assembling the plurality of codes and portions of the plurality of elements not represented by the plurality of codes into a form suitable for transmission or storage.

According to another aspect of the present invention, a method for recovering a document comprising a plurality of elements from encoded information comprises receiving the encoded information representing the document and identifying a plurality of codes therein, where a respective code has a beginning, represents at least a portion of a respective element, conveys a respective type indication indicating the respective element type and conveys a respective syntax indication indicating presence or absence of syntax information representing one or more syntactical characteristics of the respective element, obtaining respective syntax indications from respective codes at predefined positions relative to the beginning of the respective codes, generating a plurality of decoded representations, where a respective decoded representation is derived from a respective code and corresponds to the portion of the respective element that is represented by the respective code, where the respective syntax indication controls generation of decoded representations that represent syntax information and are derived in a manner such that information capacity requirements of a respective decoded representation is greater than information capacity requirements of the respective code, and assembling the plurality of decoded representations and portions of the plurality of elements not represented by the codes to generate output information representing the document.

According to yet another aspect of the present invention, a method for recovering a document from a plurality of encoded elements in a compressed form comprises processing an encoded element to identify element type and to obtain a syntax indication of element syntactical characteristics, where the syntax indication is obtained from a predefined position within the encoded element relative to the encoded element beginning and a compressed representation of the element type is expanded into an uncompressed form of a markup language tag, if the syntax indication indicates that at least one tag attribute is present, processing tag attribute information in the encoded element by expanding a compressed representation of the tag attribute information into an uncompressed form of a markup language tag-attribute name or a tag-attribute value, and if the syntax indication indicates that tag content is present, processing the tag content information in the encoded element according to a process appropriate for the tag content.

The various features of the present invention and its preferred embodiments may be better understood by referring to the following discussion and the accompanying drawings in which like reference numerals refer to like elements in the several figures. The contents of the following discussion and the drawings are set forth as examples only and should not be understood to represent limitations upon the scope of the present invention.
Fig. 1 is a schematic illustration of the major components of a system in which various aspects of the present invention may be carried out.
Fig. 2 is a block diagram of a process or device for generating a compressed representation of document elements.
Fig. 3 is a block diagram of a process or device for recovering document elements from a compressed representation.
Fig. 4 is a state diagram of a process for generating a compressed representation of document elements.
Fig. 5 is a state diagram of a process for recovering document elements from a compressed representation.
Fig. 6 is a functional flow diagram of a process for either compressing or expanding document information.
Fig. 7 illustrates a simple document expressed in a markup language.
Fig. 8 is a schematic illustration of encoded information representing the document of Fig. 7 prepared by an encoding process according to the present invention.

### Overview

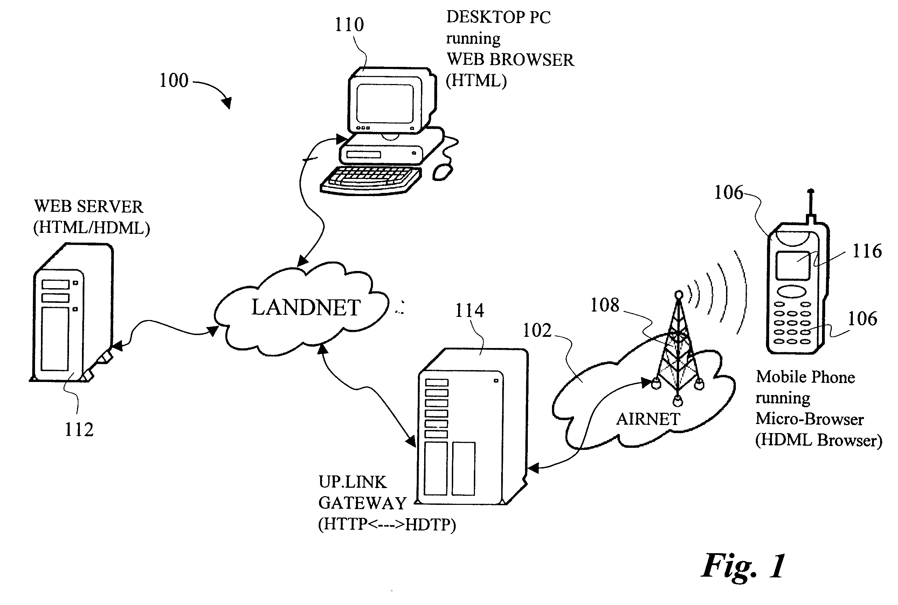

Fig. 1 illustrates in schematic form a system in which various aspects of the present invention may be practiced. Some of the components illustrated in the figure may be omitted in various embodiments. As shown, client 1 uses network 40 to access resources provided by server 51 and server 52. Although it is contemplated that server 51 and server 52 are hypermedia servers, perhaps operating in conformity with the Hypertext Transfer Protocol (HTTP), this is not necessary to practice the present invention. In typical embodiments, remote device 11 provides a user interface through which information can be presented to a user and input can be received from a user, and computer 31 exchanges information with network 40 in a manner that is consistent with a conventional network client.

Computer 31 stores parameters and information in storage 32 that typically is a combination of random access memory (RAM), read-only memory (ROM) and long-term storage devices such as magnetic and optical disk drives. Computer 31 communicates with remote device 11 through receiver 21 and transmitter 22. Information that is sent by computer 31 through transmitter 22 is received by remote device 11 through receiver 16. Information that is sent by remote device 11 through transmitter 15 is received by computer 31 through receiver 21.

In the embodiment shown in Fig. 1, remote device 11 comprises display 12, one or more buttons 13, storage 14, transmitter 15 and receiver 16. For example, device 11 may be a wireless telephone such as a MobileAccess^{TM} telephone by Mitsubishi Wireless Communications, Inc., or a Duette telephone by Samsung Electronics Corporation. In typical wireless telephones, the display 12 is a liquid crystal display (LCD) panel. Buttons 13 represent one or more data entry devices such as switches, keys or buttons. Storage 14 represents memory circuits or other devices that are capable of storing digital information. Preferably, at least part of storage 14 is persistent storage, meaning that information is retained when device 11 is turned off. In some embodiments, a portion of storage 14 is organized into a unified push/pull cache. It is also contemplated that a portion of storage 14 will store program instructions, either in persistent memory or in ROM, and that device 11 will comprise a microprocessor or other type of processing circuitry capable of executing the program instructions.

The nature of the communication paths shown between computer 31, server 51 server 52, receiver 21 and transmitter 22 are not critical to the practice of the present invention and may be implemented as switched and/or non-switched paths using private and/or public facilities, for example. Similarly, the topology of network 40 is not critical and may be implemented in a variety of ways including hierarchical and peer-to-peer networks. Computer 31 and server 51 may be located locally with respect to one another and may be implemented on the same hardware.

The nature of the communication paths between computer 31 and device 11 also is not critical to the practice of the present invention; however, in many applications device 11 is a wireless device that uses a communication technology such as electromagnetic transmission in the radio-frequency to infrared portions of the spectrum. In applications where device 11 is a wireless telephone, a cellular telephone for example, transmitter 15, receiver 16, receiver 21 and transmitter 22 represent communication facilities used for normal telephone calls.

### Remote Device

In applications where remote device 11 and computer 31 implement client 1 as a HTTP client, device 11 provides at least three basic functions: (1) a navigation function allows a user to navigate or traverse HTTP Uniform Resource Locator (URL) hyperlinks, (2) a communication function exchanges information with computer 31, and (3) an interface function provides a user interface through which information may be presented to the user and through which input may be received from the user.

Preferably, these functions are implemented by a software-controlled process using an event-driven architecture. Events may be initiated by a user through buttons 13, for example, or may be initiated by signals received through receiver 16. The navigation function operates in either of two states. In the "ready" state the device awaits user input specifying a hyperlink to traverse. In the "pending" state the communication function has submitted a request to computer 31 and the device is waiting for a reply from computer 31. In terms of the HTTP, the ready state waits for user input specifying the URL of a hypermedia entity to display or process and the pending state waits for computer 31 to provide a requested hypermedia entity.

In one embodiment, hypermedia information is exchanged with computer 31 according to the Handheld Device Transfer Protocol (HDTP). A version of this protocol is described in the "HDTP Specification," part number HDTP-SPEC-DOC-101, published July 15, 1997 by Unwired Planet, Inc., Redwood Shores, California, which is incorporated herein by reference in its entirety. The HDTP resembles the HTTP but is optimized for use with remote devices like wireless telephones and preferably is conveyed using the User Datagram Protocol/IP (UDP/IP). The UDP/IP is generally regarded as being less reliable than TCP/IP, for example, because it does not guarantee that packets will be received, nor does it guarantee that packets will be received in the same order that they are sent. Datagram protocols like the UDP/IP are attractive in practicing the present invention, however, because it does not require a "connection" to be established between a sender and a receiver before information can be exchanged. This eliminates the need to exchange a large number of packets during session creation.

In a preferred embodiment, hypermedia information is organized according to the Handheld Device Markup Language (HDML) into cards and decks. Multiple decks and other types of message entities can be organized into information structures called digests. A version of this markup language is described in the "HDML 2.0 Specification," part number HDML-SPEC-DOC-200, Revision A, published March 1997 by Unwired Planet, Inc., which is incorporated herein by reference in its entirety.

### Intermediate Computer

According to the embodiment discussed here, computer 31 together with remote device 11 provide the functions of a conventional hypermedia client. In this embodiment, computer 31 receives information from remote device 11 according to the HDTP, translates the HDTP information into corresponding HTTP information as necessary, and sends the result to server 51. Similarly, computer 31 receives information from server 51 according to the HTTP, translates the HTTP information into corresponding HDTP information as necessary, and sends the result to remote device 11. HDTP information exchanged between computer 31 and remote device 11 is compressed according to the present invention to reduce information capacity requirements and to reduce the processing required by remote device 11 to parse and interpret the information. This compression and the complementary expansion is carried out by encoding and decoding processes performed in remote device 11 and in computer 31.

### Processes

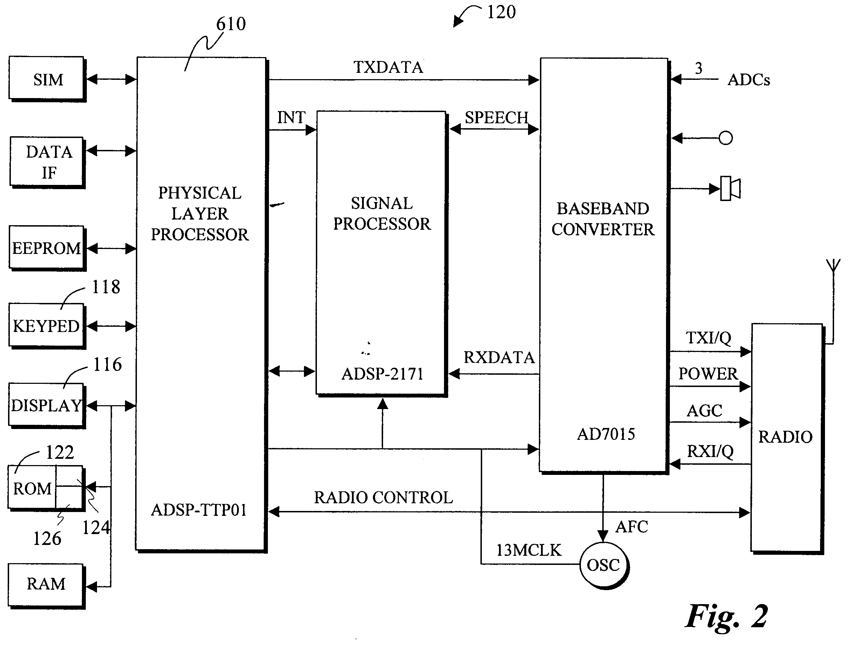

Fig. 2 illustrates one embodiment of an encoding process according to the present invention for generating a compressed representation of document elements. Identify-elements 62 receives from path 61 information representing a document and identifies a plurality of elements within that information. Elements typically have syntax information that represents at least some aspect of the structure and syntactical characteristics of the document.

Encode 64 generates a plurality of codes representing at least a portion of at least some of the document elements. At least some of the codes impose lower information capacity requirements than the element information that is represented. The codes convey the type of the element that is represented as well as an indication whether syntactical information for the element is present. Preferably, at least some of the syntactical information is encoded in a manner that lowers information capacity requirements. Element information is passed along path 63 as necessary to process any nested information. Nested information may be processed in a variety of ways including recursive processes.

Assemble 66 generates encoded information along path 67 representing a document by assembling the codes generated by encode 64 and any elements or portions of elements that are not represented by those codes into a form that is suitable for transmission or storage.

Another embodiment of the present invention includes code book 68 that provides a plurality of code books. Encode 64 adaptively selects a code book from this plurality of code books and generates one or more codes according to the selected code book. An indication of the selected code book is included with the encoded information.

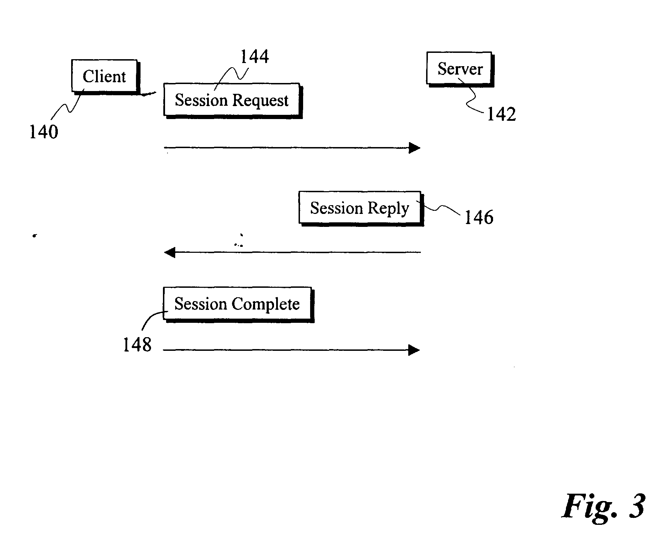

Fig. 3 illustrates one embodiment of a decoding process according to the present invention for recovering document elements from an encoded representation. Identify-codes 72 receives from path 71 encoded information representing a document and identifies a plurality of codes that each represent at least a portion of a respective document element.

In response to the codes, decode 74 obtains syntax indications and generates decoded representations. At least some of the decoded representations impose greater information capacity requirements than the corresponding codes. The syntax indications indicate the presence or absence of syntax information representing one or more syntactical characteristics of the document. Decoded representations are passed along path 73 as necessary and processed to handle any nested codes. Nested codes may be processed in a variety of ways including recursive processes.

Assemble 76 generates output information along path 77 representing the document by assembling the decoded representations generated by decode 74 and any elements or portions of elements that are not represented by those codes.

Another embodiment of the present invention includes code book 78 that provides a plurality of code books. Decode 74 adaptively selects a code book from this plurality of code books in response to an indication of a selected code book within the encoded information and generates one or more decoded representations according to the selected code book.

In yet another embodiment of the present invention, process 80 receives output information from path 77 and generates signals along path 81 that represent a presentation for display. In certain situations, decode 74 may encounter codes that cannot be decoded because the codes are unknown or unsupported by the decoding process. Decode 74 may pass these unsupported codes along path 73 for any subsequent process that is able to use the codes. Process 80 uses the syntax indication in the unsupported codes to skip or avoid processing those codes.

In a further embodiment, decode 74 includes a process similar to process 80 for generating signals that represent a presentation for display. In this embodiment, this process in decode 74 uses the element type and syntax indications conveyed in the codes to determine which codes should be skipped because, for example, the display device is unable to respond appropriately to the element represented by the codes.

### Encoding

### State Process

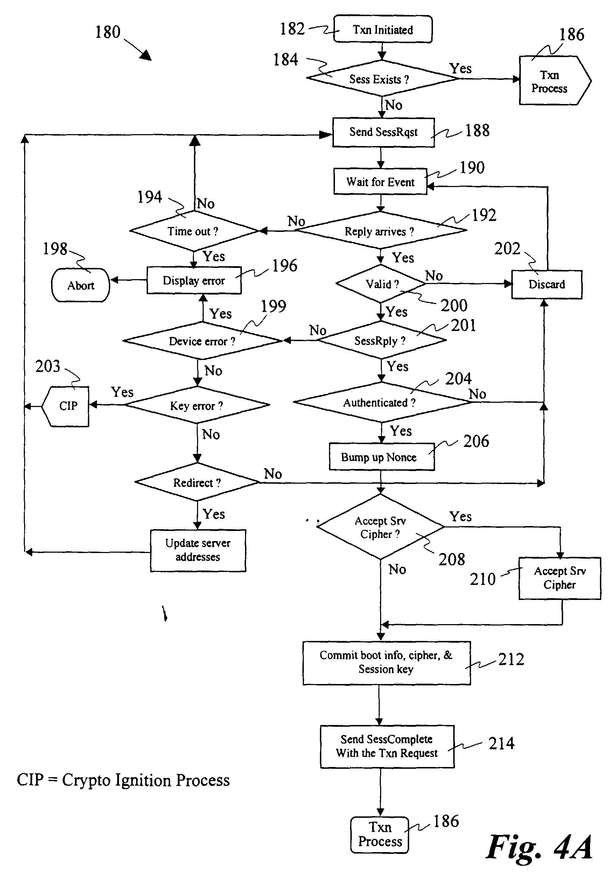

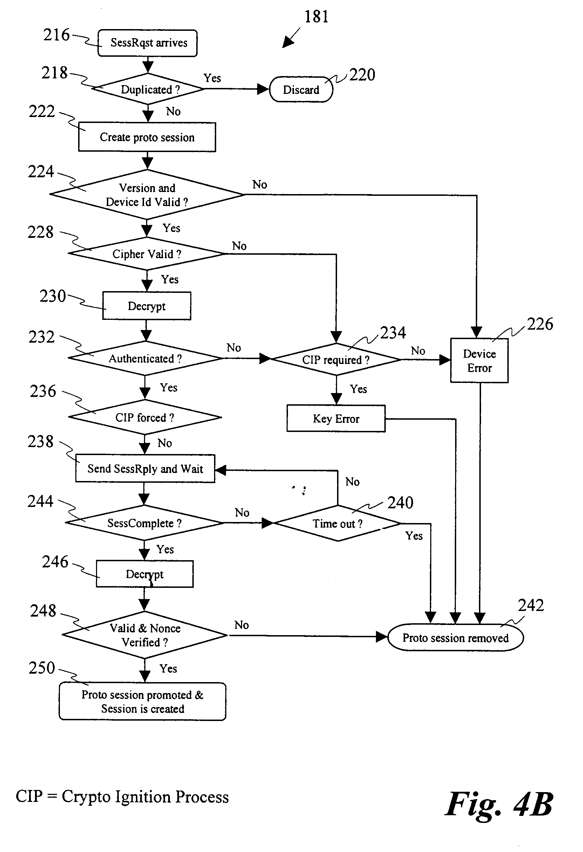

The encoding process of encode 64 may be discussed in terms of a state process such as that illustrated in Fig 4. Each of the states is represented by a circle. Transitions between states are represented by lines and occur in the directions indicated by the arrows.

The encoding process begins at state 100 (start) and makes a transition along 110 to state 101 (encode tag). State 101 generates an encoded representation of a respective element tag. If the respective element tag is not accompanied by any associated syntax information, a transition is made along path 111 to state 101 which generates an encoded representation for the subsequent element tag. If one or more tag attributes are present, a transition is made along path 112 to state 102 (encode attribute name). If no tag attributes are present but tag content is present, a transition is made along path 118 to state 105 (encode content). When no further element tags are present, a transition is made along path 122 to state 107 (end) to terminate the encoding process.

State 102 generates an encoded representation for a respective attribute name. A transition is made along path 113 to state 103 (encode attribute value). State 103 generates an encoded representation of the corresponding attribute value. If a subsequent tag attribute is present, a transition is made along 114 to state 102 which generates an encoded representation for the subsequent tag attribute.

When no further tag attributes are present, a transition is made along path 115 to state 104 (attribute end). State 104 generates a code that signals the end of the tag attributes for the respective element. If tag content is present, a transition is made along 117 to state 105 to process the tag content. If no content is present, a transition is made along path 116 to state 101 to process a subsequent element tag.

State 105 generates an encoded representation of a respective tag content. If subsequent tag content is present, a transition is made along path 119 to state 105 to process the subsequent content. When no further tag content is present, a transition is made along path 120 to state 106 (content end). State 106 generates a code that signals the end of tag content for the respective element. A transition is then made along path 121 to state 101 to process a subsequent element tag.

As will be explained in more detail below, tag content may contain nested elements. If a nested element is present, a recursive transition to state 100 is made along a path that is not illustrated. When all elements at a particular level of nesting have been processed, a recursive return transition to state 105 is made along another path that is not illustrated.

### Example

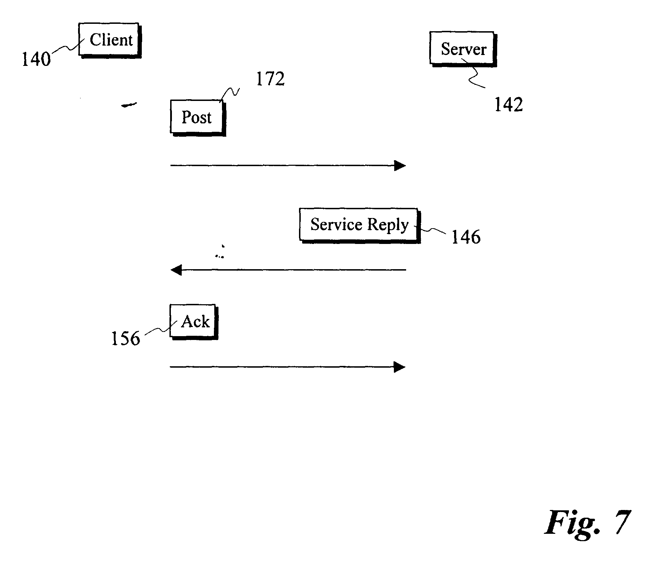

Fig. 7 illustrates a simple document expressed in a markup language such as HTML. The document is arranged in lines and each line is numbered for convenient reference in this discussion. The line numbers do not form part of the markup language. It is anticipated that, in practical embodiments, the document may be conveyed without any indication of lines or other segmentation other than that which is provided by the markup language.

Line 1 contains an <**HTML**> tag marking the beginning of an HTML document and line contains a </**HTML**> tag marking the end of the document. In this example, the <**HTML**> tag does not have attributes but it does have content, which is the body of the document marked by beginning and ending **BODY** tags on lines 2 and 7, respectively. The <**BODY**> tag does not have attributes but does have content. The content of the <**BODY**> tag is nested within the content of the <**HTML**> tag. The **BODY** tag content, which is shown in lines 3 through 6, comprises text and several tags.

The portion of the <**BODY**> tag content shown in line 3 represents simple text. The portion of the content shown in line 4 is an element with an **IMG** tag that has no content but has an attribute with a name (***src***) and a value (***"/item.gif"***) specifying the source of an image for display. The portion of the content shown in line 5 is text that contains a pair of elements with beginning and ending **B** tags marking words for display in a boldfaced font. Neither <**B**> tag has an attribute but each has text content. The portion of the content shown in line 6 is text that contains an element with beginning and ending **A** tags. The <**A**> tag has both an attribute and content. The tag attribute has a name (***href***) and a value (***"http://a.url/info"***) specifying the URL of another document. The content of the <**A**> tag is the text "here" appearing just before the ending </**A**> tag.

Fig. 8 is a schematic illustration of an encoded representation obtained by applying the encoding process discussed above to the document markup language illustrated in Fig. 7. The encoded representation as shown in Fig. 8 is arranged in lines that are numbered for convenient reference in this discussion and are indented for ease of comprehension. It is anticipated that, in practical embodiments, encoded information is generated in a form that does not contain any indication of lines or other segmentation other than that provided by the encoded representations of markup language elements.

Referring to Fig. 8, the notation {XYZ-AC} denotes a code that contains an encoded representation of markup language tag <**XYZ**> and contains an indication that one or more tag attributes are present and that tag content is present. For example, in line 1 the notation {HTML-C} denotes a code that contains an encoded representation of a <**HTML**> tag and contains an indication that no tag attribute is present but tag content is present. Similarly, the notation {IMG-A} in line 4.1 denotes a code that contains an encoded representation of a <**IMG**> tag and contains an indication that one or more tag attributes are present but no tag content is present.

According to the example shown in Fig. 8, the notation {HTML-C} shown in line 1 denotes the code that represents the <**HTML**> tag shown in line 1 of Fig. 7. As explained above, the code conveys the element type that is represented and it contains an indication that tag content is present. In line 2, the notation {BODY-C} denotes a code representing the <**BODY**> tag (line 2, Fig. 7) and indicating that tag content is present.

In line 3, the notation {STR} denotes a special code that is used to mark the presence of text. The notation "The item" represents the text itself. This code always implicitly indicates that tag content is present. Text may be marked in a variety of ways using either explicit or implicit codes. For example, the beginning of a text string may be marked implicitly by reserving certain values for text characters. Such schemes are generally context dependent because these reserved values are likely to occur in fields of binary data, for example. In preferred embodiments, the beginning of text strings are marked by an explicit code such as that represented by the notation {STR} shown in the figure. The end of a text string may be marked explicitly by a special character such as a null or binary zero, explicitly by an express length value included with the beginning code, or implicitly by a code that is not a valid text character. No particular scheme is critical to the practice of the present invention.

Lines 4.1 through 4.3 collectively represent the encoded representation of the document element shown in line 4 of Fig. 7. In line 4.1, the notation {IMG-A} denotes a code representing the <**IMG**> tag and indicating that one or more tag attributes are present. In line 4.2, the notation {src} denotes a code representing the name "src" of the tag attribute. This code may be a compressed representation of the name itself as discussed more fully below or it may be a generic attribute code indicating that the attribute name is specified in some other form such as a conventional text string. The notation ("/item.gif") denotes a conventional text string providing the value of the attribute. Alternatively, the attribute value could be encoded into some other form such as a binary code. In line 4.3, the notation {END: img-a} denotes a code marking the end of the tag attributes for the <**IMG**> tag. In one embodiment of the present invention, one code is used to mark the end of attributes and another code is used to mark the end of content. In another embodiment, different codes are used according to element type. In yet another embodiment, different codes are used to mark the end of attributes and content according to element type. Referring to the example shown in line 4.3, according to these embodiments, the notation "img-a" may be understood to represent a unique {END} code for marking the end of **IMG** attributes. In a preferred embodiment, however, one specific code such as a null or zero value is used to mark the end of attributes and content for all types of tags. For this embodiment, the notation "img-a" may be understood to be merely a convenience for the reader showing the correspondence between codes for tag attributes, content and end codes.

Lines 5.1 through 5.5 collectively represent the encoded representation of the document contents shown in line 5 of Fig. 7. In lines 5.1 and 5.3, the notation {STR} and the accompanying text denote codes and text that represent two text strings shown in line 5 of Fig. 7.

Lines 5.2.1 through 5.2.3 collectively represent the encoded representation of the first <**B**> element in line 5 of Fig. 7. In line 5.2.1, the notation {B-C} denotes a code representing the <**B**> tag. and indicating that content is present. In line 5.2.2, the text content is represented by the notation {STR} "red" as explained above. In line 5.2.3, the notation {END: b-c} denotes a code that marks the end of the content for the <**B**> tag. Similarly, lines 5.4.1 through 5.4.3 collectively represent the encoded representation of the second <**B**> element in line 5 of Fig. 7.

In line 5.5, the notation {STR} "for a limited time." represents an encoding of a text string as explained above and completes the encoded representation of the document contents shown in line 5 of Fig. 7. According to the example shown in Fig. 8, the encoded representation for the document contents in line 6 of Fig. 7 are shown in lines 6.1.1 through 6.3., collectively. In a practical embodiment of the present invention, however, the adjacent text strings "for a limited time" and "Click" could be combined into one encoded representation of denoted by {STR} "for a limited time. Click".

As just explained, lines 6.1.1 through 6.3 collectively represent the encoded representation of the document contents shown in line 6 of Fig. 7. As discussed, the notation {STR} "Click" in line 6.1.1 denotes the encoding of a text string. In line 6.1.2, the notation {A-AC} denotes a code representing the <**A**> tag. and indicating that tag attributes and content are present. In line 6.1.3, the notation {href} ("http://a.url/info") denotes an encoding that represents the name and value of the tag attribute. In line 6.1.4, the notation {END: a-a} denotes a code that marks the end of the attributes for the <**A**> tag. In line 6.2.1, the notation {STR} "here" denotes an encoding of a text string that is the tag content. In line 6.2.2, the notation {END: a-c} marks the end of the content for the <**A**> tag. The notation in line 6.3 represents a text string, which completes the encoded representation of the document contents shown in line 6 of Fig. 7.

In lines 7 and, the notations {END: body-c} and {END: html-c} denote codes that mark the end of the content for the <**BODY**> and <**HTML**> tags, respectively.

### Compression

A variety of encoding or compression schemes may be used to generate codes having information capacity requirements that are lower than the information capacity requirement of the document element, or portion of a document element, that is represented by a code. The codes are generated to convey both the type of document element that is represented and an indication whether syntax information is present in the document element. The indication of syntax information is conveyed in a predefined position relative to the beginning of the code.

According to a preferred embodiment of the invention, codes have a fixed length of one byte (8 binary bits) in which one or more bits, say the two most significant bits, are reserved to indicate whether syntax information is absent or present. For HTML, for example, two bits may be reserved to indicate the presence or absence of one or more tag attributes and tag content, respectively. Other code structures are possible including codes that are variable in length. For example, a code could include a variable length indication of element type generated by Huffmann encoding and a separate indication of syntax information. The indication of syntax information may be placed in any predefined position relative to the beginning of the code.

Rules may be established to allow the predefined position to vary according to element type. For example, the position may be defined to immediately follow a variable-length indication of element type. As another example, one position could be predefined for a class of special codes, say those that have one of several specified values, and another position could be predefined for other codes. The predefined position is fixed independent of element type in preferred embodiments.

### Special Codes

In a preferred embodiment, a class of six special codes is established. These special codes are referred to as "global codes" because, according to this embodiment, all encoders and decoders must be able to correctly interpret and process these codes. These six codes are discussed below.

A special code denoted {CBK} marks a value that specifies a code book that has been adaptively selected from a plurality of code books. Decoding is performed according to the selected code book. As explained briefly above, fixed length 8-bit codes are used to convey both element type and an indication of syntax information. If two bits are used to convey the indication of syntax information, only six bits remain to convey element type. Generally, the number of elements far exceeds what can be expressed in six bits. This limitation is even more severe because it is desirable to use these codes to also represent frequently used attribute names and/or attribute values. By organizing codes into a plurality of code books and selecting an appropriate code book from this plurality, the size of the coding space can be extended significantly. When an encoder selects a code book, an indication of the selection is assembled into the encoded information so that a complementary decoder can determine which code book should be used for decoding. The {CBK} code is to mark this indication.

A special code denoted {CHR} marks a value that specifies a character. For example, documents that are represented by text that conforms to the American Standard Code for Information Interchange (ASCII) cannot represent some of the characters defined in Unicode text. Any Unicode character can be represented by a numeric value marked by the {CHR} code.

A special code denoted {DAT} marks the start of "opaque" data that is not to be processed by the decoder. The data is said to be opaque in the sense that the internal structure of the data need not be known to the encoder. Opaque data is marked and included in the encoded information without modification. The extent of the opaque data is conveyed by a length value that accompanies the {DAT} code.

A special code denoted {END} marks the end of certain elements and syntax information as described above.

A special code denoted {STR} marks the start of a text string as described above.

A special code denoted {UNK} marks an unknown element type. The use of this code improves the ability of existing encoders and decoders to process documents that contain elements that were undefined at the time the encoders and decoders were implemented. An older encoder can pass along the unknown element in a form that allows a more recent decoder to receive and process the new element. An older decoder working in conjunction with an older encoder is able to skip the element marked by the {UNK} code and resume processing other known codes.

### Decoding

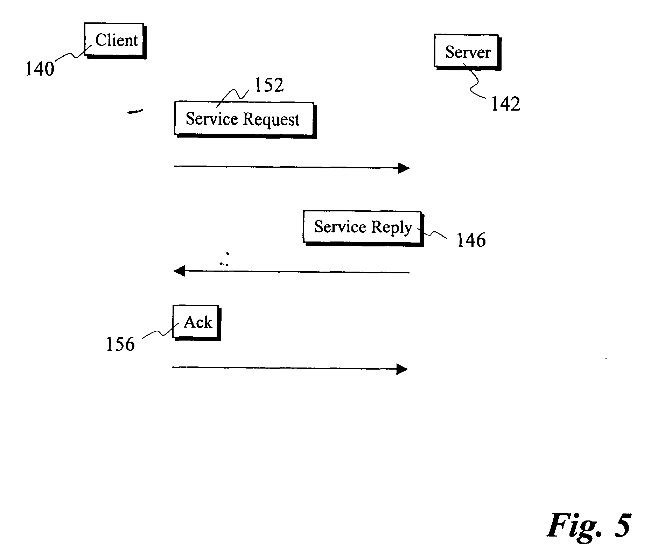

The decoding process of decode 74 may be discussed in terms of a state process such as that illustrated in Fig. 5. Each of the states is represented by a circle. Transitions between states are represented by lines and occur in the directions indicated by the arrows.

The decoding process begins at state 130 (start) and makes a transition along 140 to state 131 (decode tag). State 131 generates a decoded representation of a respective element tag that is derived from a respective code. If the respective code indicates that no syntax information is present, a transition is made along path 141 to state 131 which generates a decoded representation derived from a subsequent code. If the code indicates that one or more tag attributes are present, a transition is made along path 142 to state 132 (decode attribute name). If the code indicates that no tag attribute is present but that tag content is present, a transition is made along path 148 to state 135 (decode content). When no further element tags are present, a transition is made along path 152 to state 137 (end) to terminate the decoding process.

State 132 generates a decoded representation of a respective attribute name. A transition is made along path 143 to state 133 (decode attribute value). State 133 generates a decoded representation of the corresponding attribute value. If a subsequent tag attribute is present, a transition is made along 144 to state 132 which generates a decoded representation of the subsequent tag attribute.

When no further tag attributes are present, if tag content is present, a transition is made along 147 to state 135 to process the tag content. If no content is present, a transition is made along path 146 to state 131 to process a subsequent code.

State 135 generates a decoded representation of a respective tag content. If subsequent tag content is present, a transition is made along path 149 to state 135 to process the subsequent content. When no further tag content is present, a transition is made along path 151 to state 131 to process a subsequent code.

As will be explained above, tag content may contain nested codes. If a nested code is present, a recursive transition to state 130 is made along a path that is not illustrated. When all codes at a particular level of nesting have been processed, a recursive return transition to state 135 is made along another path that is not illustrated.

### Recursion

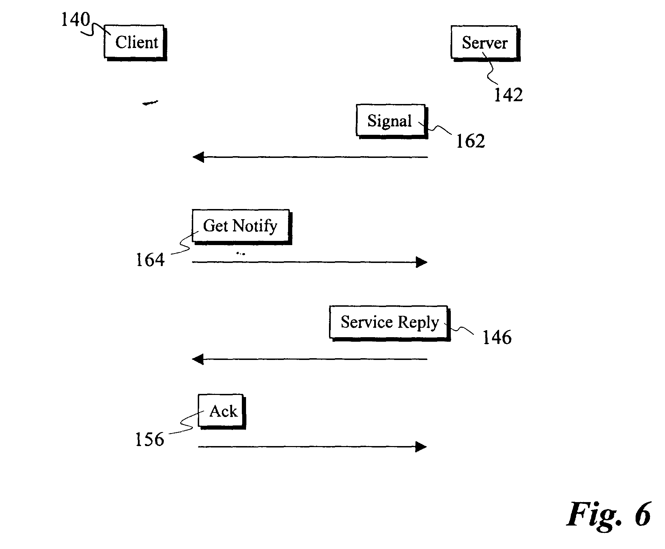

The state diagrams illustrated in Figs. 4 and 5 do not show any provision for recursion. Recursion is not required to practice the present invention but it is an efficient technique in many embodiments for processing nested elements and codes. A functional flow diagram illustrated in Fig. 6 represents a recursive process for either encoding or decoding document elements expressed in a markup language such as HTML.

### Encoding

According to the illustrated process for encoding, step 221 performs various initialization tasks. Step 222 initializes the recursion level to zero. Step 223 processes element tags to generate an encoded representation. Step 224 interrogates whether any tag attributes are present. If so, step 225 processes the tag attribute to generate an encoded representation and then returns to step 224 to interrogate whether any other tag attributes are present. When no further tag attributes are present, the process continues with step 226.

Step 226 interrogates whether tag content is present. If so, step 227 process the tag content to generate an encoded representation. Step 228 interrogates whether any elements are nested within the tag content. If not, the process returns to step 226 to interrogate whether any other tag content is present. When no further tag content is present, the process continues with step 230. If an element is nested within the tag content, step 229 increments the recursion level and the process continues with step 223.

Step 230 interrogates whether the current recursion level is zero. If it is not zero, step 231 decrements the recursion level and the process continues with step 226. If the recursion level is zero, step 232 interrogates whether the encoding process is done. If not, the process return to step 223. If the encoding process is done, step 233 performs various termination tasks.

### Decoding

According to the illustrated process for decoding, step 221 performs various initialization tasks. Step 222 initializes the recursion level to zero. Step 223 processes codes to generate a decoded representation. Step 224 interrogates whether any tag attributes are present. If so, step 225 processes the code representing the tag attribute to generate a decoded representation and then returns to step 224 to interrogate whether any other tag attributes are present. When no further tag attributes are present, the process continues with step 226.

Step 226 interrogates whether tag content is present. If so, step 227 process the code representing the tag content to generate a decoded representation. Step 228 interrogates whether any codes are nested within the encoded tag content. If not, the process returns to step 226 to interrogate whether any other tag content is present. When no further tag content is present, the process continues with step 230. If a code is nested within the encoded tag content, step 229 increments the recursion level and the process continues with step 223.

Step 230 interrogates whether the current recursion level is zero. If it is not zero, step 231 decrements the recursion level and the process continues with step 226. If the recursion level is zero, step 232 interrogates whether the decoding process is done. If not, the process return to step 223. If the decoding process is done, step 233 performs various termination tasks.

## Claims

1. A method for reducing capacity requirements of input information representing a document, the method comprising:-
receiving the input information representing the document and identifying a plurality of elements therein, wherein each element has a respective type and wherein at least some of the elements have syntax information representing one or more respective syntactical characteristics;
generating a plurality of codes, a respective code having a beginning and representing at least a portion of a respective element in a form having an information capacity requirement that is lower than the information capacity requirement of the represented portion, wherein the respective code conveys the respective element type and a syntax indication indicating presence or absence of syntax information for the respective element, and wherein the respective code conveys the syntax indication in a predefined position relative to the beginning of the respective code; and
generating encoded information representing the document by assembling the plurality of codes and portions of the plurality of elements not represented by the plurality of codes into a form suitable for transmission or storage.

2. A method according to claim 1 that further comprises selecting a code book from a plurality of code books, wherein at least some of the codes are generated according to the selected code book and an indication of the selected code book is assembled into the encoded information.

3. A method for recovering decoded information representing a document from encoded information, wherein the document comprises a plurality of elements, the method comprising:-
receiving encoded information representing the document and identifying a plurality of codes therein, wherein a respective code has a beginning, represents at least a portion of a respective element, conveys a respective type indication indicating the respective element type and conveys a respective syntax indication indicating presence or absence of syntax information representing one or more syntactical characteristics of the respective element;
obtaining respective syntax indications from respective codes at predefined positions relative to the beginning of the respective codes;
generating a plurality of decoded representations, wherein a respective decoded representation is derived from a respective code and corresponds to the portion of the respective element that is represented by the respective code, wherein the respective syntax indication controls generation of decoded representations that represent syntax information, and wherein the respective decoded representation is derived in a manner such that information capacity requirements of the respective decoded representation is greater than information capacity requirements of the respective code; and
assembling the plurality of decoded representations and portions of the plurality of elements not represented by the codes to generate output information representing the document.

4. A method according to any preceding claim wherein the elements conform to a tag-based markup language, each element comprising a markup language tag, and wherein the syntax information includes tag attribute and tag content.

5. A method according to claim 4 wherein the tag-based markup language conforms to a Standard Generalized Markup Language (SGML) Document Type Definition (DTD).

6. A method according to any preceding claim wherein the codes have a form such that the syntax indication indicates presence or absence of syntax information in a manner that is independent of element type.

7. A method according to any preceding claim as dependent on claim 4 that further comprises generating signals representing a presentation for display on a device by processing the output information according to the elements therein, wherein the processing uses the syntax indication of one or more elements in said output information to avoid processing syntax information that otherwise would affect one or more characteristics of the presentation.

8. A method according to any preceding claim as dependent on claim 4 that further comprises generating signals representing a presentation for display on a device by processing the encoded information according to the codes therein, wherein the processing uses the syntax indication of one or more codes in said encoded information to avoid processing syntax information that otherwise would affect one or more characteristics of the presentation.

9. A method according to any preceding claim as dependent on claim 4 wherein the encoded information includes one or more instances of an unsupported code from which respective decoded representations are not derived, and wherein the output information is generated by also assembling the one or more instances of the unsupported code.

10. A method according to any preceding claim wherein the codes have a fixed length and convey the syntax indication at a fixed position relative to the beginning of the codes.

11. A method according to any preceding claim as dependent on claim 4 wherein the encoded information includes an indication of a selected code book that is selected from a plurality of code books and wherein at least some of the decoded representations are derived from the codes according to the selected code book.

12. A method for recovering decoded information representing a document from encoded information comprising a plurality of encoded elements in a compressed form, the method comprising:-
processing an encoded element to identify element type and to obtain a syntax indication of element syntactical characteristics, wherein the syntax indication is obtained from a predefined position within the encoded element relative to the encoded element beginning and a compressed representation of the element type is expanded into an uncompressed form of a markup language tag;
wherein if the syntax indication indicates that at least one tag attribute is present, processing tag attribute information in the encoded element by expanding a compressed representation of the tag attribute information into an uncompressed form of a markup language tag-attribute name or a tag-attribute value; and
wherein if the syntax indication indicates that tag content is present, processing the tag content information in the encoded element according to a process appropriate for the tag content.

13. A method according to claim 12 wherein the markup language tag conforms to a Standard Generalized Markup Language (SGML) Document Type Definition (DTD).

14. A method according to claim 12 or 13 wherein the encoded elements have a form such that the syntax indication indicates presence or absence of syntax information in a manner that is independent of element type.

15. A method according to any one of claims 12 through 14 that further comprises generating signals representing a presentation for display on a device by processing the output information according to the elements therein, wherein the processing uses the syntax indication of one or more elements in said output information to avoid processing tag attribute information or tag content that otherwise would affect one or more characteristics of the presentation.

16. A method according to any one of claims 12 through 15 wherein the encoded information includes one or more instances of encoded elements of an unsupported type that are not expanded into an uncompressed form of a markup language tag, and wherein the output information is generated by also assembling the one or more instances of encoded elements of the unsupported type.

17. A method according to any one of claims 12 through 16 wherein the encoded information includes an indication of a selected code book that is selected from a plurality of code books and wherein the markup language tag, tag-attribute name or tag-attribute value is expanded into an uncompressed form according to the selected code book.

18. A method according to any one of claims 12 through 17 wherein the compressed representation of element type has a fixed length and the syntax indication is conveyed at a fixed position within the compressed representation of element type.
